# EUROPÄISCHE PATENTANMELDUNG

(11) **EP 3 460 839 A1**
(43) Veröffentlichungstag der Anmeldung: **27.03.2019**
(21) Anmeldenummer: 17192470.7
(22) Anmeldetag: 21.09.2017
(51) Int. Cl.: H01L 23/373

(54) **FOLIEN FÜR DEN EINSATZ IN DER HALBLEITERTECHNIK**

(71) Anmelder: GWP Gesellschaft Für Werkstoffprüfung MbH, 85604 Zorneding (DE)
(72) Erfinder: NICKL, Julius, 83553 Jakobneuharting (DE)
(74) Vertreter: Sommer, Andrea

(57) **Zusammenfassung**

Die vorliegende Erfindung betrifft eine Folie umfassend eine Matrix, einen Füllstoff und zwei sich gegenüberliegende Oberflächen, wobei der Füllstoff eine größere Wärmeleitfähigkeit als die Matrix aufweist und der Folie eine größere Wärmeleitfähigkeit in der Richtung senkrecht zu den Oberflächen verleiht als parallel zu den Oberflächen. Ferner betrifft die vorliegende Erfindung die Verwendung dieser Folie in der Halbleitertechnik, insbesondere als Wärmleitfolie. Die Erfindung betrifft ebenfalls eine Vorrichtung umfassend ein Halbleiterbauteil, eine Kühlvorrichtung und eine erfindungsgemäße Folie, wobei sich die Folie zwischen Halbleiterbauteil und Kühlvorrichtung befindet und mit dem Halbleiterbauteil und der Kühlvorrichtung wärmeleitend verbunden ist. Ein weiterer Aspekt der vorliegenden Erfindung betrifft Verfahren zur Herstellung der Folie.

## Beschreibung

### Einleitung

Die vorliegende Erfindung betrifft eine Folie umfassend eine Matrix, einen Füllstoff und zwei sich gegenüberliegende Oberflächen, wobei der Füllstoff eine größere Wärmeleitfähigkeit als die Matrix aufweist und der Folie eine größere Wärmeleitfähigkeit in der Richtung senkrecht zu den Oberflächen verleiht als parallel zu den Oberflächen. Ferner betrifft die vorliegende Erfindung die Verwendung dieser Folie in der Halbleitertechnik, insbesondere als Wärmleitfolie. Die Erfindung betrifft ebenfalls eine Vorrichtung umfassend ein Halbleiterbauteil, eine Kühlvorrichtung und eine erfindungsgemäße Folie, wobei sich die Folie zwischen Halbleiterbauteil und Kühlvorrichtung befindet und mit dem Halbleiterbauteil und der Kühlvorrichtung wärmeleitend verbunden ist. Ein weiterer Aspekt der vorliegenden Erfindung betrifft Verfahren zur Herstellung der Folie.

### Stand der Technik

Bei den elektronischen Bauteilen ist der Trend zu höherer Leistungsdichte ungebrochen. Dies betrifft zum Beispiel Bauteile der Leistungselektronik (z.B. IGBT, Thyristoren, Wechselrichter und Gleichrichter), der LED-Technik und auch Bauteile für die Datenverarbeitung (z.B. Mikroprozessor, Speicher). Die dabei entstehende Abwärme muss abgeführt werden, da sich sonst das Bauteil über die Betriebstemperatur erwärmt. Eine übermäßige Erwärmung der Elektronik kann sowohl zu einer Verringerung der Leistung als auch zur Beschädigung der Bauteile bis hin zum Totalausfall führen. Auch kann die Lebensdauer der Bauteile bei erhöhten Temperaturen stark herabgesetzt werden. Daher ist das thermische Management in der Elektronik ein wichtiger konstruktiver Aspekt. Es werden viele unterschiedliche Methoden und Strategien zum Temperaturmanagement eingesetzt wie zum Beispiel Kühlkörper, Ventilatoren, Leitpasten, Heatpipes, Wasserkühlung, Wärmeleitfolien und Wärmeleitpads. Jede Methode hat ihre Vorteile und Nachteile im Einsatz. Häufig werden Kombinationen eingesetzt. Generell gilt, dass die Industrie passive Bausteine vorzieht, die elektrisch nicht leitend sein sollen, bzw. einen hohen Durchschlagwiderstand aufweisen müssen und einfach verarbeitet werden können.

Es wurden verschiedene Wärmeleitfolien für die Wärmeableitung bei gleichzeitiger elektrischer Isolation entwickelt, zum Beispiel Silikongummi-Folien und -Hülsen, teilweise mit Glasfasergewebe-Einlage, großflächige Silikonmatten zur wärmeleitenden und gleichzeitig vibrationsdämpfenden Montage, beispielsweise zwischen SMD (surface-mount technology)-bestückten Leiterkarten und Kühlkörpern oder Gehäuseteilen, die als Kühlkörper dienen. Glimmerscheiben werden seit langem zur elektrischen Isolation zum Beispiel zwischen Halbleitern und Kühlkörpern eingesetzt. Auch Keramikscheiben, meist aus Aluminiumoxidkeramik, werden eingesetzt. Kunststofffolien (Kapton), die teilweise mit Paraffin-Beschichtung zur Füllung von Lufträumen durch Aufschmelzen im Betrieb oder mit einer selbstklebenden Beschichtung konfektioniert sind, werden ebenfalls verwendet. Gleiches gilt für Phase-Change-Materialien.

Die unterschiedlichen Bauteilgrößen, die verschiedene Höhe der Verlustleistung bzw. Wärmestromdichte haben zu der Entwicklung von verschiedenen Folientypen geführt. Ein weiterer wichtiger Punkt der für die Wärmeleitfolien spricht, ist die einfache Handhabung in der Produktion. Hier zeigen sich die Vorteile der Folie gegenüber anderen Lösungen, wie der z.B. der Wärmeleitpaste. Eine Vielzahl von Wärmeleitfolien sind am Markt erhältlich, die zum Teil keramische Füllmaterialien enthalten. Die tatsächliche Wärmeleitfähigkeit dieser Folien liegt bei etwa 7 Wm⁻¹K⁻¹ oder weniger, auch wenn gelegentlich eine besserer Wärmeleitfähigkeit behauptet wird, wobei auch nicht immer klar ist, wie die angegebenen Wärmeleitfähigkeiten gemessen wurden.

Wärmeleitfolien, in kleinen Dimensionen auch Wärmepads genannt, sind thermisch leitfähige Folien, die zumeist als Isolator, also elektrisch nicht leitend, ausgelegt sind. Sie bestehen bevorzugt aus relativ weichem Material, das für einen für geringen Anpressdruck bei gutem Kontakt sorgt. Eine Ausführungsform diesen Wärmeleitfolien sind partikelverstärkte Silikone. Je nach Anforderungen und Preis können zum Beispiel Bornitrid-Partikel oder Aluminiumoxid-Partikel verwendet werden. Die Partikel liegen in diesen Materialien ungeordnet vor. Die Fertigung erfolgt in der Regel mittels eines Rakels der den (unausgehärteten) Verbund auf die gewünscht Dicke einstellt.

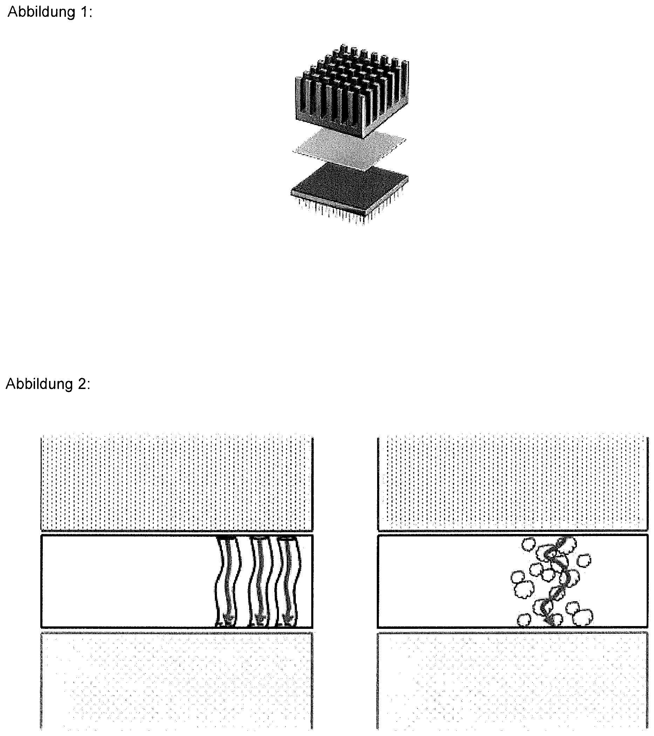

Für Kühlkörper haben sich Wärmeleitfolien und Wärmepads wegen der Zuverlässigkeit und der einfachen Montage durchgesetzt. Abbildung 1 zeigt den schematischen Aufbau einer Kühlanordnung für Halbleiter. Unten ist der Halbleiterbaustein gezeigt. In der Mitte ist die Wärmeleitfolie gezeigt und oben ist der Kühlkörper gezeigt.

Um einen optimalen Übergang von der zu kühlenden Komponente zum Kühlkörper, zu gewährleisten, ist der Einsatz von Wärmeleitmaterialien notwendig. Durch die Verwendung von Wärmeleitfolien werden Unebenheiten der Oberflächen ausgeglichen und die darin befindliche Umgebungsluft mit der Gefahr eines Wärmestaus verdrängt (siehe Abbildung 1). Weiterhin fungieren die Wärmeleitfolien in der Regel als elektrische Isolatoren.

### Aufgabe der Erfindung

Es ist die Aufgabe der vorliegenden Erfindung neuartige Folien, insbesondere Wärmeleitfolien zur Verfügung zu stellen. Diese sollen eine möglichst hohe Wärmeleitfähigkeit senkrecht zur Oberfläche aufweisen. Sie sollen ferner bevorzugt gute elektrische Isolatoren sein. Weiter sollen die erfindungsgemäßen Folien industriell leicht herstellbar sein und die Folien sollen viele oder alle der üblichen Anforderungen an Wärmeleitfolien erfüllen.

### Beschreibung der Erfindung

Die vorstehenden Probleme werden gelöst, durch eine Folie umfassend eine Matrix, einen Füllstoff und zwei sich gegenüberliegende Oberflächen, wobei der Füllstoff eine größere Wärmeleitfähigkeit als die Matrix aufweist und der Folie eine größere Wärmeleitfähigkeit in der Richtung senkrecht zu den Oberflächen verleiht als parallel zu den Oberflächen. Die Folie ist bevorzugt eine Wärmeleitfolie. Die Messung der Wärmeleitfähigkeit erfolgt nach DIN EN ISO 22007-6:2015-05. Bevorzugt ist eine erfindungsgemäße Folie, wie hierin beschrieben, worin der Füllstoff eine ausrichtbare Orientierung der höchsten Wärmeleitfähigkeit aufweist und innerhalb der Folie so ausgerichtet ist, dass er der Folie eine größere Wärmeleitfähigkeit in der Richtung senkrecht zu den Oberflächen verleiht als parallel zu den Oberflächen. Die Wärmeleitfähigkeit einer Folie die eine Matrix und einen Füllstoff aufweist ist beschränkt durch die Menge an Füllstoff, die die Matrix aufnehmen kann. Eine Folie in der der Füllstoff eine ausrichtbarer Orientierung der höchsten Wärmeleitfähigkeit aufweist und in der der Füllstoff innerhalb der Folie so ausgerichtet ist, dass er der Folie eine größere Wärmeleitfähigkeit in der Richtung senkrecht zu den Oberflächen verleiht als parallel zu den Oberflächen hat den Vorteil, dass er bei gleicher Matrix und gleichem Füllstoff und gleichen Mengen von Matrix und Füllstoff eine höhere Wärmeleitfähigkeit in Richtung senkrecht der Oberflächen aufweist als eine herkömmliche Folie. Das heißt, als eine Folie die Füllstoff enthält, worin der Füllstoff jedoch keine ausrichtbarer Orientierung der höchsten Wärmeleitfähigkeit aufweist oder in der der Füllstoff eine ausrichtbare Orientierung der höchsten Wärmeleitfähigkeit aufweist, der Füllstoff innerhalb der Folie jedoch nicht so ausgerichtet ist, dass er der Folie eine größere Wärmeleitfähigkeit in der Richtung senkrecht zu den Oberflächen verleiht als parallel zu den Oberflächen. Die erhöhte Wärmeleitfähigkeit senkrecht zu den Oberflächen ist insbesondere erwünscht bei der Verwendung der Folien als Wärmeleitfolien.

Der Füllstoff enthält bevorzugt Partikel. Besonders bevorzugt besteht er daraus. Als Partikel im Sinne der vorliegenden Erfindung gelten alle partikulären Materialien, die in eine Matrix eingebettet werden können. Art und Form der Partikel ist nicht besonders beschränkt. Sie weisen jedoch ganz besonders bevorzugt eine ausrichtbare Orientierung der höchsten Wärmeleitfähigkeit auf. Die Partikel liegen bevorzugt in vereinzelter Form vor.

Bevorzugt weißt wenigstens ein Teil der Partikel des Füllstoffs keine Kugelform auf. Die Achse der insgesamt maximalen Ausdehnung eines solchen Partikels wird im Folgenden als Längsachse bezeichnet. Sollte das Partikel mehrere Achsen enthalten, die die insgesamt maximale Ausdehnung aufweisen, wie zum Beispiel runde oder quadratische Plättchen usw., so kann eine beliebige dieser Achsen als Längsachse ausgewählt werden. Bevorzugt sind jedoch Partikel, die die insgesamt maximale Ausdehnung nur in einer Richtung aufweisen. Da die Partikel nicht rund sind, haben Sie zumindest in einer Richtung senkrecht zu der Längsachse eine maximale Ausdehnung, die geringer als die maximale Ausdehnung in Richtung der Längsachse des Partikels ist. Die Partikel können zum Beispiel Fasern, ovale Partikel, nadelförmige Kristalle oder Plättchen sein. Bevorzugt sind Fasern. Die Partikel müssen zumindest in einer Richtung eine gegenüber der Matrix höhere Wärmeleitfähigkeit aufweisen. Es ist besonders bevorzugt, dass solche Partikel zumindest in Richtung der Längsachse eine größere Wärmeleitfähigkeit aufweisen als das Material der Matrix. Bevorzugt ist das Verhältnis der maximalen Ausdehnung in Richtung der Längsachse zur maximalen Ausdehnung in Richtung senkrecht zur Längsachse mindestens 2 zu 1, besonders bevorzugt mindestens 3 zu 1 und noch mehr bevorzugt zumindest 5 zu 1. Diese gilt insbesondere für Fasern. Sind die Partikel Fasern aus flexiblem Material, so wird das Verhältnis in dem Zustand zu messen, in dem die Fasern gerade ausgestreckt sind. In einer bevorzugten Ausführungsform der vorliegenden Erfindung ist wenigstens ein Teil der Partikel in der Folie so ausgerichtet, dass die Folie senkrecht zu den Oberflächen eine höhere Wärmeleitfähigkeit aufweist, als parallel dazu. Besonders bevorzugt sind die Partikel so ausgerichtet, dass die Folie senkrecht zu den Oberflächen eine um wenigstens 2 Wm⁻¹K⁻¹ höhere, bevorzugt eine um wenigstens 4 Wm⁻¹K⁻¹ höhere, besonders bevorzugt eine um wenigstens 5 Wm⁻¹K⁻¹ höhere Wärmeleitfähigkeit aufweist, als parallel dazu.

Abbildung 2 illustriert den Vorteil der erfindungsgemäßen Folie gegenüber dem Stand der Technik. Es handelt sich um eine schematische Darstellung der erfindungsgemäßen Folie zwischen einer Wärmequelle (oben) und einer Wärmesenke (unten). Links ist die Anordnung von Fasern gezeigt, die in Richtung ihrer höchsten Wärmeleitfähigkeit ausgerichtet sind. Rechts ist die Anordnung von Partikeln gezeigt, die keine Orientierung aufweisen. Wie man leicht sehen kann ist die Weglänge die zur Wärmeableitung überwunden werden muss, im Fall von nicht orientierten Partikeln länger. Zusätzlich müssen im Fall von nicht orientierten Partikeln mehrfach Phasengrenzen zwischen den Partikeln und der Matrix oder zwischen zwei Partikeln überwunden werden, was die Wärmeleitfähigkeit zusätzlich behindert.

Bevorzugt ist eine Folie in denen der Füllstoff Partikel enthält oder daraus besteht, die eine anisotrope Wärmeleitfähigkeit aufweisen. Besonders bevorzugt sind Partikel die sowohl eine anisotrope Wärmeleitfähigkeit als auch eine ausrichtbare Orientierung der höchsten Wärmeleitfähigkeit aufweisen. In einer ganz besonders bevorzugten Ausführungsform umfasst der Füllstoff der erfindungsgemäßen Folie Partikel, die in Richtung der Längsachse der Partikel eine größere Wärmeleitfähigkeit aufweisen als senkrecht dazu. Besonders bevorzugt bestehen wenigstens 80 % der Masse des Füllstoffs aus solchen Partikeln. Ebenfalls bevorzugt bestehen wenigstens 80 % des Volumens des Füllstoffs aus solchen Partikeln. Am meisten bevorzugt besteht der Füllstoff vollständig aus solchen Partikeln. Am meisten bevorzugt ist eine erfindungsgemäße Folie, worin die Partikel in Richtung der Längsachse eine größere Wärmeleitfähigkeit aufweisen als senkrecht dazu und der Folie eine größere Wärmeleitfähigkeit in der Richtung senkrecht zu den Oberflächen verleiht als parallel zu den Oberflächen. Die erhöhe Wärmeleitfähigkeit der Folie in Richtung der senkrecht zu den Oberflächen entsteht dabei einerseits dadurch, dass die Längsachse der Partikel so orientiert ist, das sie im Mittel mehr in Richtung senkrecht zu den Oberflächen ausgerichtet sind als parallel dazu. Im Idealfall sind die Längsachsen aller Partikel (oder Fasern) senkrecht zu der Oberfläche der Folie ausgerichtet. Da die Partikel eine höhere Wärmeleitfähigkeit als die Matrix aufweisen, wird durch die Orientierung der Partikel die Wärme auf einer längeren Wegstrecke durch das Material der Partikel transportiert und somit die Wärmeleitfähigkeit erhöht. Zusätzlich wird die Wärmeleitfähigkeit noch dadurch erhöht, dass die Wärmeleitfähigkeit in Längsrichtung der Partikel höher ist als senkrecht dazu. Dies erhöht den Effekt der Orientierung der Längsachse der Partikel senkrecht zu den Oberflächen der Folie zusätzlich.

In einer bevorzugten Ausführungsform der vorliegenden Erfindung hat wenigstens ein Teil der Partikel eine Längsachse (siehe oben) und der durchschnittliche Winkel der Längsachse der Partikel zur den Oberflächen der Folie beträgt mehr als 45°. Handelt es sich bei den Partikel um flexible Partikel, insbesondere um flexible Fasern, so wird als Längsachse zur Bestimmung des Winkels eine Gerade von einem Endpunkt des Partikels zum anderen Endpunkt des Partikels, insbesondere der Faser, angenommen. Als Endpunkt wird dabei der Punkt genommen, der im gestreckten Zustand der Partikel der Endpunkt wäre. In dieser Ausführungsform sind die Partikel daher nicht statistisch verteilt, sondern ein größerer Anteil davon ist in Richtung von einer Oberfläche zur anderen Oberfläche ausgerichtet. Dies führt dazu, dass die Partikel die Wärme über eine längere Wegstrecke leiten. Da die Partikel eine höhere Wärmeleitfähigkeit als die Matrix haben wird die Wärmeleitfähigkeit der Folien in Richtung senkrecht auf die Oberflächen der Folie erhöht. Ganz besonders bevorzugt ist es wenn wenigstens ein Teil der Partikel so angeordnet ist, dass sich das eine Ende der Partikel an der einen Oberfläche befindet und sich das andere Ende desselben Partikels an der anderen Oberfläche befindet, wobei das Ende der Partikel so definiert ist, dass es den äußersten Punkt auf der Längsachse des Partikels bedeutet. Bei einer solchen Ausrichtung der Partikel ist die Wärmeleit-fähigkeit der Folie erhöht. Am meisten bevorzugt sind die Partikel dabei Fasern. Folien in denen die Partikel eine anisotrope Wärmeleitfähigkeit aufweisen, die in Richtung der Längsachse der Partikel größer ist als senkrecht dazu, wie vorstehend beschrieben, bewirken bei einer solchen Orientierung der Partikel eine besonders hohe Wärmeleitfähigkeit senkrecht zu den Oberflächen. Folien in denen diese Merkmale kombiniert sind, sind daher besonders bevorzugt.

Die erfindungsgemäßen Folien weisen bevorzugt eine Wärmeleitfähigkeit von 7 Wm⁻¹K⁻¹ oder mehr, bevorzugt von 10 Wm⁻¹K⁻¹ oder mehr, besonders bevorzugt von 12 Wm⁻¹K⁻¹ oder mehr, ganz besonders bevorzugt von 15 Wm⁻¹K⁻¹ oder mehr und am meisten bevorzugt von 20 Wm⁻¹K⁻¹ oder mehr auf.

Bevorzugt bildet die Matrix eine kontinuierliche Phase, in die der Füllstoff als diskontinuierliche Phase eingebettet ist.

Das Material der Matrix kann ein organisches oder anorganisches Polymer enthalten. Bevorzugt besteht das Material der Matrix aus einem organischen oder anorganischen Polymer. Bevorzugt enthält die Matrix ein thermoplastisches Elastomer. Besonders bevorzugt besteht sie daraus. Die Matrix enthält bevorzug wenigstens ein Material, das ausgesucht ist aus der Gruppe bestehend aus Silikonen, Silikonharzen, Polyurethan und Ethylen-Propylen-Dien-Kautschuk und deren Gemischen. Bevorzugt besteht die Matrix aus wenigstens einem dieser Materialien oder deren Gemischen. Es ist weiterhin bevorzugt, dass das Material der Matrix ein Silikon enthält. Es ist ebenfalls bevorzugt, wenn das Material der Matrix ein Silikonharz enthält oder, besonders bevorzugt, daraus besteht. Am meisten bevorzugt besteht das Material der Matrix aus Silikon. Die Matrix kann zusätzlich verschiedene Hilfsstoffe enthalten, die zum Beispiel ausgesucht sein können aus wenigstens einem Hilfsstoff ausgewählt aus der Gruppe bestehend aus Verdickungsmittel, Farbstoffe, Weichmacher, Füllstoffe mit einer gleiche oder geringeren Wärmeleitfähigkeit als die Matrix, Reste von Substanzen, die bei der Herstellung der Matrix anfallen, wie zum Beispiel Reste aus einer Polymerisation.

Bevorzugt ist eine Folie wie vorstehend beschrieben, worin der Unterschied der Wärmeleitfähigkeit der Matrix und der Wärmeleitfähigkeit des Füllstoffs wenigstens 10 Wm⁻¹K⁻¹ oder mehr, bevorzugt 50 Wm-1K-1 oder mehr, besonders bevorzugt 100 Wm⁻¹K⁻¹ oder mehr, ganz besonders bevorzugt 120 Wm⁻¹K⁻¹ oder mehr beträgt und am meisten bevorzugt 150 Wm⁻¹K⁻¹ oder mehr beträgt. Als Füllstoff kommen alle hochwärmeleitfähigen Materialien in Betracht. Der Füllstoff weist bevorzugt eine Wärmeleitfähigkeit von wenigstens 20 Wm⁻¹K⁻¹ oder mehr, besonders bevorzugt von 50 Wm⁻¹K⁻¹ oder mehr, ganz besonders bevorzugt von 100 Wm⁻¹K⁻¹ oder mehr, noch mehr bevorzugt von 130 Wm⁻¹K⁻¹ oder mehr auf und am meisten bevorzugt eine Wärmeleitfähigkeit von 160 Wm⁻¹K⁻¹ oder mehr aufweist.

Werden in der vorliegenden Erfindung Fasern als Füllstoffe eingesetzt, so haben die Fasern bevorzugt einen Durchmesser von 1 µm bis 1 mm, besonders bevorzugt von 1 µm bis 100 µm, ganz besonders bevorzugt von 3 µm bis 50 µm und am meisten bevorzugt von 3 µm bis 20 µm. Die Fasern weisen dabei in Faserrichtung bevorzugt eine Wärmeleitfähigkeit von wenigstens 20 Wm⁻¹K⁻¹ oder mehr, besonders bevorzugt von 50 Wm⁻¹K⁻¹ oder mehr, ganz besonders bevorzugt von 100 Wm⁻¹K⁻¹ oder mehr, noch mehr bevorzugt von 130 Wm⁻¹K⁻¹ oder mehr auf und am meisten bevorzugt eine Wärmeleitfähigkeit von 160 Wm⁻¹K⁻¹ oder mehr auf.

Die Partikel sollten gute wärmeleitende Eigenschaften aufweisen. Die Partikel der erfindungsgemäßen Folie können organisches und anorganisches Material enthalten oder daraus bestehen. Bevorzugt ist anorganisches Material, einschließlich Metalle. Ebenfalls bevorzugt enthält wenigstens ein Teil der Partikel wenigstens ein Material, dass ausgewählt ist aus der Gruppe bestehend aus Metallen, Siliciumcarbid, Aluminiumoxid, Bornitrid, Grafen, Graphit und Polyethylen. Es ist besonders bevorzugt, dass alle Partikel wenigstens ein Material enthalten, das aus dieser Gruppe ausgewählt ist. Ferner kann wenigstens ein Teil der Partikel aus einem Material bestehen, dass ausgewählt ist aus dieser Gruppe. Am meisten bevorzugt bestehen alle Partikel des Füllstoffs aus einem Material, das aus dieser Gruppe ausgewählt ist.

Siliciumcarbid, Aluminiumoxid und Bornitrid haben eine besonders hohe Wärmeleitfähigkeit und sind industriell verfügbar. Besonders bevorzugt ist daher eine erfindungsgemäße Folie wie hierin beschrieben, dadurch gekennzeichnet, dass das Material der Partikel aus Siliciumcarbid besteht oder aus Aluminiumoxid besteht oder dass es Siliciumcarbid und Aluminiumoxid, aber keine weiteren Bestandteile enthält. Ganz besonders bevorzugt enthält das Material der Partikel Siliciumcarbid. Noch mehr bevorzugt ist es wenn das Material der Partikel aus Siliciumcarbid besteht. Am meisten bevorzugt enthält das Material der Partikel ß-Siliciumcarbid oder besteht daraus.

Bevorzugt enthält die erfindungsgemäße Folie Plättchen (Flakes) oder Fasern. Besonders bevorzugt handelt es sich bei den Plättchen um Nanoplättchen (nano flakes). Bevorzugt sind Nanoplättchen, bei denen die Raumrichtung mit der kleinsten Ausdehnung eine Dicke von 100 nm oder weniger aufweist. Wenn die Folie Plättchen enthält handelt es sich dabei bevorzugt um Plättchen (Flakes) die Bornitrid, Siliziumcarbid oder Grafen enthalten oder daraus bestehen.

Besonders bevorzugt enthält die erfindungsgemäße Folie jedoch Fasern. Dabei ist es ganz besonders bevorzugt, dass wenigstens ein Teil dieser Fasern ausgesucht ist aus der Gruppe bestehend aus Metallfasern, insbesondere Kupferfasern, Kohlenstofffasern, Graphitfasern, Siliciumcarbidfasern, Bornitridfasern, Aluminiumoxidfasern und "Ultra High Density Polyethylene" (UHD-Polyethylene) Nanofasern im kristallisierten bzw. teilkristallisiertem Zustand. Am meisten bevorzugt sind alle Fasern aus dieser Gruppe ausgewählt. Bei Verwendung von Polyethylen sind UHD-Polyethylen-Nanofasern im kristallisierten oder teilkristallisierten Zustand mit einer Wärmeleitfähigkeit von 100 Wm-1K-1 oder mehr in Richtung der Längsrichtung der Fasern bevorzugt. Bevorzugt sind Nanofasern die einen Durchmesser von 1000 nm oder weniger, bevorzugt von 500 nm oder weniger aufweisen.

Bevorzugt beträgt der Partikelvolumengehalt der erfindungsgemäßen Folien 5 % bis 70 %, besonders bevorzugt 10 % bis 60 %, ganz besonders bevorzugt 20 bis 55 % und am meisten bevorzugt 30 % bis 45 %. Der Partikelvolumengehalt oder bei Fasern auch der Faservolumengehalt ist der Anteil des Volumens der Partikel am Gesamtvolumen der Folie. Dieser kann bestimmt werden durch Bestimmung der Größe der Flächen der Partikel und der Matrix auf einem Querschnitt der Folie. Die Fläche der Partikel geteilt durch die Gesamtfläche ergibt den Partikelvolumengehalt. Ein hoher Gehalt an Partikel führt zu einer hohen Wärmeleitfähigkeit, kann jedoch die mechanischen Eigenschaften der Folie beeinträchtigen und umgekehrt. Dieser Parameter kann daher je nach Anwendung und verwendeten Materialien geeignet eingestellt werden.

Ebenfalls bevorzugt ist eine Ausführungsform der vorliegenden Erfindung worin das Material der Matrix aus einem oder mehreren elektrischen Nichtleiter besteht. Bevorzugt besteht das Material des Füllstoffs aus einem oder mehreren elektrischen Nichtleitern. Besonders bevorzugt besteht sowohl das Material der Matrix als auch das Material des Füllstoffs aus elektrischen Nichtleitern. Die Durchschlagsspannung der Folie ist bevorzugt größer oder gleich 1,5 kV. Die Folien gemäß der vorliegenden Erfindung sind bevorzugt dadurch kennzeichnet, dass die Folienstärke 0,01 bis 1 mm beträgt, besonders bevorzugt 0,05 bis 0,5 mm, ganz besonders bevorzugt 0,05 bis 0,22 mm und am meisten bevorzugt 0,09 bis 0,11 mm. Die Shore-Härte gemäß DIN EN ISO 868 und DIN ISO 7619-1 der erfindungsgemäßen Folien beträgt bevorzugt 20 bis 60, besonders bevorzugt 30 bis 50 und ganz besonders bevorzugt 35 bis 45. Ferner ist es bevorzugt, wenn die Folien gemäß der vorliegenden Erfindung in der Entflammbarkeitsprüfung nach UL-94 bei einer Folienstärke von 0,1 mm die Anforderungen der Stufe V-0 erfüllen. Die in diesem Absatz genannten Folien eignen sich besonders gut zum Einsatz als Wärmeleitfolien in der Elektronik.

Ein weiterer Aspekt der vorliegenden Erfindung ist eine Vorrichtung umfassend ein Halbleiterbauteil, eine Kühlvorrichtung und eine Folie, wie hierin beschrieben, wobei sich die Folie zwischen Halbleiterbauteil und Kühlvorrichtung befindet und mit dem Halbleiterbauteil und der Kühlvorrichtung wärmeleitend verbunden ist. Zwischen der Folie und dem Halbleiterbauteil oder zwischen der Folie und der Kühlvorrichtung kann zusätzlich noch eine elektrisch isolierende Folie eingefügt werden. Dies erhöht die elektrisch isolierenden Eigenschaften für besondere Anwendungen.

Ein weiterer Aspekt der vorliegenden Erfindung ist die Verwendung einer Folie wie hierin beschrieben in der Hableitertechnik. Bevorzugt ist die Verwendung einer Folie wie hierin beschrieben als Wärmeleitfolie für ein Halbleiterbauteil.

Ein weiterer Aspekt der vorliegenden Erfindung ist ein Verfahren zur Herstellung einer Folie wie hierin beschrieben, dadurch gekennzeichnet, dass die folgenden Verfahrensschritte durchgeführt werden:
- Bereitstellen von Partikeln, die eine ausrichtbare Orientierung der maximalen Wärmeleitfähigkeit aufweisen,
- Bereitstellen eines Fluids, das zu einer festen Matrix gehärtet werden kann,
- Suspendieren der Partikel in dem Fluid,
- Orientieren wenigstens eines Teils der Partikel in dem Fluid,
- Härten des Fluids zu einer Matrix und
- Schneiden der Matrix zu einer Folie mit zwei Oberflächen senkrecht zu den orientierten Partikeln.

Dieses Verfahren dient insbesondere der Herstellung der erfindungsgemäßen Folien.

In dem Verfahren gemäß der vorliegenden Erfindung kann das Orientieren der Partikel durch alle möglichen bekannten Methoden erfolgen. Wichtig ist in der Regel nur, dass die Partikel nach dem Orientieren wie gewünscht ausgerichtet sind. Ziel ist es dabei, die Partikel so auszurichten, dass in dem Fluid bzw. in der Matrix eine Richtung mit einer hohen Wärmleitfähigkeit entsteht. Im Idealfall werden alle Partikel oder Fasern genau parallel ausgerichtet. Wird die Matrix dann senkrecht zu dieser Ausrichtung geschnitten, so entstehen Folien mit maximaler Wärmleitfähigkeit. Es kommt daher darauf an, so viele Partikel wie möglich, so weit wie möglich in dieselbe Richtung auszurichten. Bevorzugt wird das das Orientieren der Partikel in dem Fluid durch Scherkräfte erzeugt, also beispielsweise durch Erzeugen einer Strömung in dem Fluid. Bevorzugt wird das Orientieren der Partikel durch Durchleiten des die Partikel enthaltenden Fluids durch eine Leitung erzeugt. Dabei kann das Fluid auch in der Leitung gehärtet werden. Als Leitung kann jede geeignete Vorrichtung verwendet werden, insbesondere ein Rohr oder ein Schlauch. In einer besonders bevorzugten Ausführungsform wird das die Partikel enthaltende Fluid zum Orientieren der Partikel durch ein Rohr oder einen Schlauch extrudiert. Eine weitere Methode zum parallelen Orientieren der Fasern ist das Austreiben durch Querschnittsverengung. Ferner können vereinzelte Fasern gespannt und mit dem Fluid infiltriert werden.

Die Dichte der Partikel, die Dichte des Fluids und Viskosität des Fluids müssen dabei so gewählt werden, dass sich die Partikel zwischen dem Suspendieren und dem Härten nicht entmischen oder nur zu einem geringen Teil entmischen. Ferner sollten sie so gewählt werden, dass die Orientierung der Partikel zwischen dem Orientieren und dem Härten nicht verloren geht oder jedenfalls nur teilweise verloren geht. Die notwendigen Verhältnisse lassen sich leicht anhand von Vorversuchen einstellen. Lässt sich die Matrix nicht verarbeiten, so muss die Viskosität der Matrix verringert werden. Nimmt die Orientierung der Partikel nach dem Schritt in der die Orientierung vorgenommen wird ab, was entweder Mikroskopisch anhand eines Querschnitts der Matrix oder durch Messung der Wärmeleitfähigkeit gemessen werden kann, so kann die Viskosität der Matrix erhöht werden. Das Fluid ist in der Regel niederviskos bis pastös. Bevorzugt liegt die dynamische Viskosität der Matrix nicht unter 10 cPs, besonders bevorzugt nicht unter 50 cPs, ganz besonders bevorzugt nicht unter 100 cPs und am meisten bevorzugt nicht unter 500 cPs liegen. Bei sehr geringer Viskosität ist es aufwendig die Konvektion in dem Fluid zu verhindern, so dass sich die Orientierung der Partikel zwischen Orientierung und Härten ändern kann. Die dynamische Viskosität soll andererseits bevorzugt nicht höher als 500.000 cPs, besonders bevorzugt nicht höher als 200.000 cPs, ganz besonders bevorzugt nicht höher als 100.000 cPs und am meisten bevorzugt nicht höher als 50.000 cPs sein. Ist die Viskosität zu hoch, so leidet die Verarbeitbarkeit. Die Viskosität kann während der Verarbeitung unter anderem durch Temperaturänderung reguliert werden. Dies gilt insbesondere für thermoplastische Polymere. Dem Fluid können auch übliche Verdickungsmittel zugefügt werden.

Zur Härtung kann eine beliebige Methode eingesetzt werden. Bevorzugt ist eine Methode die ausgesucht ist aus der Gruppe bestehend aus thermische Polymerisierung, Erkalten eines Thermoplasten, Strahlungshärtung, wasserinduzierte Polymerisation und Hybridhärtung. Im erfindungsgemäßen Verfahren kann ein Fluid eingesetzt werden das chemisch härtbar ist und die Härtung kann dabei durch chemische Härtung erfolgen. Bevorzugt ist ein erfindungsgemäßes Verfahren, worin das Fluid zu einem Elastomer härtbar ist. Ebenfalls bevorzugt wird im erfindungsgemäßen Verfahren ein Fluid eingesetzt, das ein thermoplastisches Elastomer enthält. Besonders bevorzug besteht das Fluid aus einem thermoplastischen Elastomer. Das Fluid enthält daher bevorzugt ein geschmolzenes thermoplastisches Elastomer oder besteht daraus. In solchen Fällen erfolgt das Härten bevorzugt durch Abkühlen des Fluids.

Das Schneiden der gehärteten Matrix kann bei einer genügenden Shore-Härte einfach durch Abschneiden von Folien mit einem Messer quer zu der Richtung erfolgen in der das Fluid extrudiert wurde, das heißt quer zur Orientierung der Partikel. Weist die gehärtete Matrix eine Shore-Härte von 10 oder weniger auf, kann die Shore-Härte durch Kühlen der gehärteten Matrix erhöht werden, um das Schneiden mit einem Messer zu ermöglichen.

Es sind erfindungsgemäße Verfahren bevorzugt, bei denen das Schneiden so erfolgt, dass wenigstens ein Teil der Partikel so angeordnet ist, dass sich das eine Ende einer Partikel an der einen Oberfläche der Folie befindet und sich das andere Ende derselben Partikel an der anderen Oberfläche der Folie befindet. Besonders bevorzugt ist diese Ausführungsform, in der es sich bei den Partikeln um Fasern handelt.

Im erfindungsgemäßen Verfahren ist die Länge der eingesetzten Partikel in Richtung der Längsachse in der Regel von 0,1 bis 10 cm, bevorzugt von 0,5 bis 5 cm, besonders bevorzugt von 0,7 bis 3 cm und am meisten bevorzugt von 0,8 bis 1,5 cm. Dies gilt insbesondere, wenn es sich bei den Partikeln um Fasern handelt. Im Übrigen gelten für die im Verfahren eingesetzten Partikel alle Ausführungen die vorstehend zu den in den erfindungsgemäßen Folien gemacht wurden entsprechend.

Bei einer weiteren Methode wird das Fluid vor der parallelen Orientierung gehärtet oder teilgehärtet und anschließend wird die gehärtete oder teilgehärtete Matrix gestreckt. Diese Methode umfasst die folgenden Verfahrensschritte:
- Bereitstellen von Partikeln, die eine ausrichtbare Orientierung der maximalen Wärmeleitfähigkeit aufweisen,
- Bereitstellen eines Fluids, das zu einer festen Matrix gehärtet werden kann,
- Suspendieren der Partikel in dem Fluid,
- Härten oder teilweise Härten des Fluids zu einer Matrix,
- Orientieren wenigstens eines Teils der Partikel in der gehärteten oder teilgehärteten Matrix, durch Strecken der Matrix
- gegebenenfalls Nachhärten der teilgehärteten Matrix zu einer Matrix und
- Schneiden der Matrix zu einer Folie mit zwei Oberflächen senkrecht zu den orientierten Partikeln.

Die gestreckte Matrix kann dann optional vor dem Schneiden nachgehärtet werden. Das NachHärten kann jedoch unterbleiben, wenn die Matrix auch ohne Nachhärtung eine geeignete Shore-Härte aufweist.

Bevorzugt wird bei allen erfindungsgemäßen Verfahren eine Matrix aus thermoplastischem Material verwendet. Hierbei wird vor dem Orientieren die benötigte Plastizität durch Einstellung einer geeigneten Temperatur eingestellt und nach dem Orientieren die Matrix auf Zimmertemperatur abgekühlt, wenn die Temperatur bei dem Orientieren über der Zimmertemperatur lag.

Fasern sind für das erfindungsgemäße Verfahren besonders geeignet. Die Fasern müssen dabei im Verhältnis zur Matrix eine geeignete Härte und Flexibilität aufweisen. Geeignete Verhältnisse der Härte und Flexibilität der Fasern zu der Härte der Matrix lassen sich leicht durch Vorversuche ermitteln.

In einer weiteren bevorzugten Ausführungsform des erfindungsgemäßen Verfahrens wie hierin beschrieben, wird das die Partikel enthaltende Fluid nach dem Orientieren wenigstens eines Teils der Partikel in dem Fluid, zum Härten in eine Form gegeben wird und darin zu einer Masse gehärtet wird.

Ein weiterer Aspekt der vorliegenden Erfindung sind erfindungsgemäße Folien, wie hierin beschrieben, die nach einem erfindungsgemäßen Verfahren hergestellt werden, wie hierin beschrieben.

Kurze Beschreibung der Abbildungen:
- Abbildung 1:: Schematischer Aufbau einer Kühlanordnung für Halbleiter. Unten: Halbleiterbaustein, Mitte: Wärmeleitfolie, Oben: Kühlkörper.
- Abbildung 2:: Abbildung 2 zeigt eine schematische Darstellung einer erfindungsgemäßen Folie und einer Folie gemäß dem Stand der Technik.

### Beispiele:

### Messmethoden:

Wärmeleitfähigkeit und Temperaturleitfähigkeit werden gemäß DIN EN ISO 22007-6:2015-05 gemessen. Die Shore-Härte wird gemäß DIN EN ISO 868 und DIN ISO 7619-1 gemessen.

### Beispiel 1:

100 g zylinderförmige Kupferfasern mit einer Länge von 2-4 mm und einem Durchmesser von 80 µm werden durch eine rüttelnde Schiene vereinzelt und in 500 ml lufthärtendem Silikon eingerührt, dass eine Shore-Härte von A 15 aufweist. Die Mischung wird in eine handelsübliche Klebstoffpatrone gefüllt und per Handmechanismus durch eine Düse mit einem Innendurchmesser von 6 mm in eine U-förmige Aluminiumform mit einer Tiefe von 6 mm und einer Weite von 6 mm gefüllt. Das Fluid wird über Nacht durch Stehenlassen an der Luft ausgehärtet. Die gehärtete Masse wird der Aluminium-Schiene entnommen und mit einem Teppichmesser werden senkrecht zur Länge der gehärteten Masse Scheiben mit einer Dicke von 0,5 mm und Scheiben mit einer Dicke von 1,0 mm abgeschnitten. Die so erhaltene Folie hat eine Wärmeleitfähigkeit von 20 Wm⁻¹K⁻¹.

### Zum Vergleich:

Eine Folie aus Silikon ohne Kupferfasern weist eine Wärmeleitfähigkeit von etwa 0,5 Wm⁻¹K⁻¹ auf. Eine Folie aus Silikon mit Kupferfasern, die wie vorstehend hergestellt wurde, wobei jedoch die Kupferfasern nicht orientiert sind, weist eine Wärmeleitfähigkeit von etwa 5 Wm⁻¹K⁻¹ auf.

### Beispiel 2:

10 g Kohlenstofffasern (high modulus) enthaltend 2 % Epoxy-Schlichte mit einer durchschnittlichen Länge von 6 mm und einem Durchmesser von 8 µm werden in 100 ml lufthärtendem Silikon eingerührt, dass eine Shore-Härte von A 15 aufweist. Die Fasern werden anschließend durch Behandlung der Mischung im Rührbecher mit einer Ultraschall-Sonotrode vereinzelt. Die Mischung wird in eine handelsübliche Klebstoffpatrone gefüllt und per Handmechanismus durch eine Düse mit einem Innendurchmesser von 6 mm in eine U-förmige Aluminiumform mit einer Tiefe von 6 mm und einer Weite von 6 mm gefüllt. Das Fluid wird über Nacht durch Stehenlassen an der Luft ausgehärtet. Die gehärtete Masse wird der Aluminiumform entnommen, auf -80 °C gekühlt und mit ultraschallunterstütztem Messer senkrecht zur Länge der gehärteten Masse in Scheiben mit einer Dicke von 0,5 mm geschnitten. Die so erhaltene Folie hat eine Wärmeleitfähigkeit von 15 Wm⁻¹K⁻¹.

### Zum Vergleich:

Eine Folie aus Silikon ohne Kohlenstofffasern weist eine Wärmeleitfähigkeit von etwa 0,5 Wm⁻¹K⁻¹ auf. Eine Folie aus Silikon mit Kohlenstofffasern, die wie vorstehend hergestellt wurde, wobei jedoch die Kohlenstofffasern nicht orientiert sind, weist eine Wärmeleitfähigkeit von etwa 4 Wm⁻¹K⁻¹ auf.

## Patentansprüche

1. Folie umfassend eine Matrix, einen Füllstoff und zwei sich gegenüberliegende Oberflächen, wobei der Füllstoff eine größere Wärmeleitfähigkeit als die Matrix aufweist und der Folie eine größere Wärmeleitfähigkeit in der Richtung senkrecht zu den Oberflächen verleiht als parallel zu den Oberflächen.

2. Folie gemäß Anspruch 1, worin der Füllstoff eine ausrichtbare Orientierung der höchsten Wärmeleitfähigkeit aufweist und innerhalb der Folie so ausgerichtet ist, dass er der Folie eine größere Wärmeleitfähigkeit in der Richtung senkrecht zu den Oberflächen verleiht als parallel zu den Oberflächen.

3. Folie nach einem der Ansprüche 1 oder 2, worin der Füllstoff Partikel enthält.

4. Folie nach einem der Ansprüche 1, 2 oder 3, worin der Füllstoff Partikel enthält die eine anisotrope Wärmeleitfähigkeit aufweisen.

5. Folie gemäß wenigstens einem der vorangehenden Ansprüche, worin der Füllstoff Partikel umfasst, die in Richtung der Längsachse der Partikel eine größere Wärmeleitfähigkeit aufweisen als senkrecht dazu.

6. Folie gemäß Anspruch 5, worin die Partikel in Richtung der Längsachse eine größere Wärmeleitfähigkeit aufweisen als senkrecht dazu und der Folie eine größere Wärmeleitfähigkeit in der Richtung senkrecht zu den Oberflächen verleiht als parallel zu den Oberflächen.

7. Folie gemäß wenigstens einem der vorangehenden Ansprüche, worin die Partikel Plättchen oder Fasern und bevorzugt Fasern sind.

8. Folie gemäß wenigstens einem der vorangehenden Ansprüche, worin die Matrix aus einem oder mehreren elektrischen Nichtleiter besteht.

9. Folie gemäß wenigstens einem der vorangehenden Ansprüche, worin die Matrix bevorzug wenigstens ein Material enthält das ausgesucht ist aus der Gruppe bestehend aus Silikonen, Silikonharzen, Polyurethan und Ethylen-Propylen-Dien-Kautschuk und deren Gemischen.

10. Folie gemäß wenigstens einem der vorangehenden Ansprüche, umfassend Partikel umfassend wenigstens ein Material das ausgewählt ist aus der Gruppe bestehend aus Metallen, Siliciumcarbid, Aluminiumoxid, Bornitrid, Grafen, Graphit und Polyethylen.

11. Vorrichtung umfassend ein Halbleiterbauteil, eine Kühlvorrichtung und eine Folie, gemäß wenigstens einem der vorangehenden Ansprüche, wobei sich die Folie zwischen Halbleiterbauteil und Kühlvorrichtung befindet und mit dem Halbleiterbauteil und der Kühlvorrichtung wärmeleitend verbunden ist.

12. Verwendung einer Folie gemäß wenigstens einem der vorangehenden Ansprüche in der Hableitertechnik.

13. Verfahren zur Herstellung einer Folie wie hierin beschrieben, **dadurch gekennzeichnet, dass** die folgenden Verfahrensschritte durchgeführt werden:
- Bereitstellen von Partikeln, die eine ausrichtbare Orientierung der maximalen Wärmeleitfähigkeit aufweisen,
- Bereitstellen eines Fluids, das zu einer festen Matrix gehärtet werden kann,
- Suspendieren der Partikel in dem Fluid,
- Orientieren wenigstens eines Teils der Partikel in dem Fluid,
- Härten des Fluids zu einer Matrix und
- Schneiden der Matrix zu einer Folie mit zwei Oberflächen senkrecht zu den orientierten Partikeln.

14. Verfahren nach Anspruch 13, worin die Partikel Plättchen oder Fasern und bevorzugt Fasern sind.

15. Verfahren nach wenigstens einem der Ansprüche 13 oder 14, worin das Fluid aus einem geschmolzenen thermoplastischen Elastomer besteht.
